# EUROPÄISCHE PATENTSCHRIFT

(11) **EP 2 664 934 B1**
(45) Veröffentlichungstag und Bekanntmachung des Hinweises auf die Patenterteilung: **18.07.2018**
(21) Anmeldenummer: 13002412.8
(22) Anmeldetag: 06.05.2013
(51) Int. Cl.: G01R 31/28, G01R 1/04

(54) **Testsystem für Funktionstest einer integrierten Schaltung mit Sensorvorrichtung**
Test system for functional test of integrated circuit with sensor device
Système de test pour test de fonctionnement de circuit intégré comportant un capteur

(30) Priorität: 18.05.2012 DE 102012009796
(43) Veröffentlichungstag der Anmeldung: 20.11.2013
(73) Patentinhaber: TDK-Micronas GmbH, 79108 Freiburg (DE)
(72) Erfinder: Becker, Sebastian, 79206 Oberrimsingen (DE); Kutscher, Werner, 79395 Neuenburg (DE)
(74) Vertreter: Koch Müller Patentanwaltsgesellschaft mbH

(56) Entgegenhaltungen:
- DE-A1-102006 015 365
- GB-A- 2 325 358
- GB-A- 2 401 432
- JP-A- 2002 164 136
- US-A- 5 172 049
- US-A- 6 078 185
- US-A1- 2003 117 162
- US-A1- 2005 225 346
- US-A1- 2010 052 721
- US-B1- 6 335 629

## Beschreibung

Die Erfindung betrifft ein Testsystem gemäß dem Oberbegriff des Patentanspruchs 1.
Aus der US 6 732 127 B2 ist ein Testsystem mit einer Manipulationsvorrichtung, wobei die Manipulationsvorrichtung auch als Handler bezeichnet wird und einer Testeinheit mit einem Testkopf bekannt. Mit dem Testsystem wird ein gehäuster integrierter Schaltkreis, der eine Oberseite und eine Unterseite aufweist und an der Unterseite mehrere elektrische Anschlusskontakte ausgebildet sind, mit der Unterseite nach unten in eine passende Fassung in der Manipulationsvorrichtung eingelegt. Die Anschlusskontakte zeigen nunmehr in Richtung auf die Testeinheit. Während eines Messzyklus werden die Anschlusskontakte von der Testeinheit unmittelbar kontaktiert und die elektrischen Parameter des Schaltkreises vermessen. Des Weiteren ist aus der US 2010 / 052721 A1 ein weiteres Testsystem mit einer Manipulationseinrichtung bekannt.
Des Weiteren sind aus der US 5 172 049 A, der US 2005 0 225 346 A1 und der DE 60 2004 008 562 T2 sind weitere Testvorrichtungen bekannt.
Vor diesem Hintergrund besteht die Aufgabe der Erfindung darin, eine Vorrichtung anzugeben, die den Stand der Technik weiterbildet.
Die Aufgabe wird durch ein Testsystem mit den Merkmalen des Patentanspruchs 1 gelöst. Vorteilhafte Ausgestaltungen der Erfindung sind Gegenstand von Unteransprüchen.
Gemäß dem Gegenstand der Erfindung wird ein Testsystem mit einer Manipulationsvorrichtung und einer Testeinheit bereitgestellt, wobei die Manipulationsvorrichtung eine Aufnahmeeinheit mit einer Fassung aufweist und die Fassung einen gehäusten integrierten Schaltkreis aufnimmt, und der gehäuste integrierte Schaltkreis eine Oberseite und eine Unterseite aufweist, und an der Unterseite mehrere elektrische Anschlusskontakte ausgebildet sind, und zwischen der Fassung und den Anschlusskontakten eine elektrische Verbindung besteht, und die Manipulationsvorrichtung mittels der Aufnahmeeinheit in einem ersten Zustand den integrierten Schaltkreis für die Testeinheit bereitstellt, und wobei während des ersten Zustands die Testeinheit oberhalb der Oberseite des integrierten Schaltkreises angeordnet Ist, und mit der Manipulationsvorrichtung eine Verbindung ausbildet, und die Testeinheit einen Funktionstest an der integrierten Schaltung ausführt, wobei an der Oberseite eine Sensorvorrichtung ausgebildet ist, und die Oberseite des integrierten Schaltkreises in Richtung der Testeinheit ausgerichtet ist und die elektrischen Anschlusskontakte mit der Aufnahmeeinheit der Manipulationsvorrichtung elektrisch verbunden sind. Es sei angemerkt, dass mittels der Manipulationseinrichtung, welche auch als Handler bezeichnet wird, die mit einem Gehäuse versehenden integrierten Schaltkreise (IC) in die Fassung eingesteckt und nach dem Einstecken die Schaltkreise mit der Testeinheit elektrisch verbunden werden. Derartige Testsysteme werden insbesondere für das Endmessen von Halbleiterschaltkreise nach dem Molden verwendet und als Tester bezeichnet. Des Weiteren sei angemerkt, dass sich je nach Ausführungsart der Fassung unterschiedliche IC-Gehäuseformen, wie beispielsweise QFN, QFP, DIP oder SOT gehäuste IC, messen lassen.

Ein Vorteil des Testsystems ist es, dass bei integrierten Schaltkreisen eine an der Oberfläche des Gehäuses angeordnete Sensoreinrichtung sich auf einfache und zuverlässige Weise prüfen lässt. Eine aufwendige Umrüstung des Handlers mit der Montage einer speziellen auf das jeweilige Handlersystem angepassten Manipulationseinrichtung, die eine Prüfvorrichtung für die Sensoranordnung enthält, entfällt. Im Unterschied zu der bekannten Lösung werden nunmehr die gehäusten integrierten Schaltkreise, d.h. die ICs auf dem Rücken in dem Händler transportiert. Eine derartige Ausführung wird auch als "geflippt" oder als "dead bug" bezeichnet. Die Prüfvorrichtung für die Sensorvorrichtung, die beispielsweise als Gaskammer für eine Prüfung der Funktionen eines Gassensors oder Feuchtesensors ausgebildet ist, lässt sich unmittelbar mit der Testeinheit vorzugsweise gasdicht verbinden.

In einer Weiterbildung weist die Aufnahmeeinheit eine Kopplungsvorrichtung auf, wobei die Fassung, welche den integrierten Schaltkreis aufnimmt, mittels der Kopplungsvorrichtung mit der Testeinheit elektrisch verbunden ist. Gemäß einer anderen Weiterbildung weist die Testeinheit eine Aufnahmevorrichtung für die Kopplungseinrichtung auf, wobei die Aufnahmevorrichtung eine elektrische Verbindung zwischen der Testeinheit und der Kopplungseinrichtung herstellt. Ein Vorteil ist, dass die Manipulationsvorrichtung, d.h. der Handler, nicht mit den Messkarten, die in der Testeinheit angeordnet sind, ausgerüstet werden muss, da die Fassung elektrisch über die Kopplungseinrichtung und über die Aufnahmevorrichtung mit der Testeinheit verbunden ist. Ein weiterer Vorteil ist, dass das Montieren der Aufnahmevorrichtung und der Kopplungsvorrichtung, welche in dem ersten Zustand für das Messen bzw. Prüfen zusätzlich zu der elektrischen Verbindung vorzugsweise eine kraftschlüssige und formschlüssige Verbindung aufweisen, sowohl an dem Handler als auch der Testeinheit einfach und schnell auszuführen ist. Untersuchungen haben gezeigt, dass sich die handelsüblichen Tester, d.h. das Standardequiment, ohne weiteres für die Umrüstung d.h. das Anbauen der Kopplungseinrichtung und der Aufnahmeeinrichtung eignen.

Gemäß der Erfindung weist der integrierte Schaltkreis an der Oberseite in dem Gehäuse eine Öffnung auf, wobei die Sensoreinrichtung in der Öffnung angeordnet ist. In einer bevorzugten Ausführungsform weist der integrierte Schaltkreis einen in der Öffnung ausgebildeten Lichtsensor auf. In einer anderen Ausführungsform umfasst die Sensorvorrichtung zusätzlich oder alternativ zu dem Lichtsensor einen Gassensor und / oder einen Feuchtesensor.

In einer anderen Weiterbildung weist die Testeinheit eine Gaskammer auf, wobei die Gaskammer während des ersten Zustandes mit der Oberfläche des integrierten Schaltkreises gasdicht verbunden ist. Vorzugsweise überdeckt die Gaskammer, die ebenfalls eine als Öffnung ausgebildete Ausformung aufweist, die Öffnung an der Oberseite des Gehäuses vollständig. Untersuchungen haben gezeigt, dass es vorteilhaft ist, zwischen der Gaskammer und der Oberfläche des integrierten Schaltkreises eine elastische Dichtlippe auszubilden. Ein Vorteil der elastischen Dichtlippe ist, dass auf einfache Weise eine gasdichte Verbindung zwischen der Gaskammer und der Öffnung auf der Oberseite erzielen lässt und eine Beschädigung beim Anflanschen der Gaskammer an die Oberseite des Gehäuses verhindert wird.

Des Weiteren sei angemerkt, dass die Gaskammer entsprechende Vorrats- und / oder Versorgungsanschlüsse aufweist. Hierdurch lässt sich gemäß in einer anderen Ausbildung in dem ersten Zustand innerhalb der Gaskammer eine vorgegebene Gaskonzentration und / oder Feuchtekonzentration ausbilden.

Es hat sich gezeigt, dass sich das Testsystem für eine Messung von elektrischen Parametern der elektrischen Schaltkreise, vorzugsweise in Abhängigkeit der Zusammensetzung des Gases innerhalb der Gaskammer verwenden lässt. Hierdurch lässt sich ohne Umbau neben der elektrischen Funktion einer integrierten Schaltung an dem Testsystem die Funktion der integrierten Sensorvorrichtung prüfen. Es versteht sich, dass für das Messen bzw. Prüfen des integrierten Schaltkreises die Testeinheit in einem ersten Zustand mit dem Handler in eine mechanische Verbindung gebracht wird. Nach dem Prüfen bzw. Messen des integrierten Schaltkreises während des ersten Zustandes, entfernt sich in einem zweiten Zustand der Handler von der Testeinheit und entfernt den gemessenen Schaltkreis aus der Fassung, um einen weiteren Schaltkreis in die Fassung einzuführen.

Die Erfindung wird nachfolgend unter Bezugnahme auf die Zeichnungen näher erläutert. Hierbei werden gleichartige Teile mit identischen Bezeichnungen beschriftet. Die dargestellte Ausführungsformen sind stark schematisiert, d.h. die Abstände und laterale und vertikale Erstreckung sind nicht maßstäblich und weisen, sofern nicht anders angegeben auch keine ableitbare geometrische Relation zueinander auf. Darin zeigt die einzige
- Figur: eine schematische Querschnittsansicht einer erfindungsgemäßen Testeinheit.

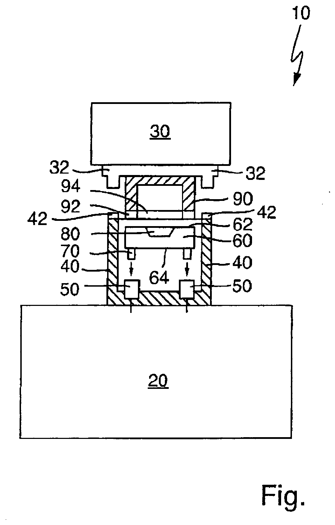

Die einzige Figur zeigt ein Testsystem 10 mit einer Manipulationsvorrichtung 20 und einer Testeinheit 30. Aus Gründen der Übersichtlichkeit sind ein Teil der Komponenten des Testsystems 10 in einem nicht zusammengefügten Zustand dargestellt. Die Manipulationsvorrichtung 20, auch Handler genannt, weist eine Aufnahmeeinheit 40 mit einer Fassung 50 auf, wobei die Fassung 50 einen gehäusten Integrierten Schaltkreis 60 aufnimmt. Die Aufnahmeeinheit 40 ist mit der Fassung 50 elektrisch verschaltet. Bei dem gehäusten integrierten Schaltkreis 60, der eine Oberseite 62 und eine Unterseite 64 aufweist, sind an der Unterseite 64 mehrere elektrische Anschlusskontakte 70 ausgebildet. Sofern der integrierte Schaltkreis 60 eingesteckt ist, besteht zwischen der Fassung 50 und den Anschlusskontakten 70 eine elektrische Verbindung. Die Manipulationsvorrichtung 20 stellt mittels der Aufnahmeeinheit 40 in einem ersten Zustand den integrierten Schaltkreis 60 für die Testeinheit 30 bereit. Hierbei ist in dem ersten Zustand die Testeinheit 30 oberhalb der Oberseite 62 des integrierten Schaltkreises 60 angeordnet und bildet mit der Manipulationsvorrichtung 20 eine mechanische, d. h. kraftschlüssige und formschlüssige Verbindung aus, sodass sich mittels der Testeinheit 30 ein Funktionstest an dem integrierten Schaltkreis 60 und der Sensorvorrichtung ausführen lässt. An der Oberseite 62 des integrierten Schaltkreises 60 ist eine Sensorvorrichtung ausgebildet, wobei die Oberseite 62 des integrierten Schaltkreises 60 in Richtung der Testeinheit 30 ausgerichtet ist und die elektrischen Anschlusskontakte 70 mit der Aufnahmeeinheit 40 der Manipulationsvorrichtung 20 elektrisch verbunden sind. Mittels der Aufnahmeeinheit 40 ist der Handler mit einer Kopplungsvorrichtung 42 elektrisch und mechanisch mit der Testeinheit 30 verbunden. Zum Koppeln mit der Kopplungseinrichtung 42 weist die Testeinheit 30 eine speziell ausgeformte Aufnahmevorrichtung 32 auf. Mittels der Aufnahmevorrichtung 32 wird eine elektrische Verbindung zwischen der Testeinheit 30 und der Kopplungseinrichtung 42 herstellt. Des Weiteren weist die Testeinheit eine Gaskammer 90 mit einer als Öffnung ausgebildeten Ausformung 92 auf, wobei die Gaskammer 90 während des ersten Zustandes mit der Oberfläche 62 des integrierten Schaltkreises 60 gasdicht verbunden ist.

Der integrierte Schaltkreis 60 weist in dem Gehäuse an der Oberseite 62 eine Öffnung 80 und eine in der Öffnung 80 ausgebildete Sensorvorrichtung - nicht dargestellt - auf. Vorliegend ist die Sensorvorrichtung als Gassensor ausgebildet. Während des ersten Zustands überdeckt die als Öffnung ausgebildeten Ausformung 94 die Öffnung 80 vollständig, wobei zwischen der Gaskammer 90 und der Oberfläche 62 des integrierten Schaltkreises 60 eine elastische Dichtlippe 92 ausgebildet ist. Vorzugsweise bildet die Gaskammer 90 eine gasdichte Verbindung mit der Öffnung 80 aus. In dem ersten Zustand wird innerhalb der Gaskammer 90 eine vorgegebene Gaskonzentration und / oder Feuchtekonzentration eingestellt und die elektrischen Parametern des elektrischen Schaltkreises 60 und insbesondere der Sensoreinrichtung in Abhängigkeit der Zusammensetzung des Gases innerhalb der Gaskammer 90 gemessen. Anders ausgedrückt wird hierdurch die Funktionsfähigkeit des gesamten Schaltkreises inklusive der Sensorvorrichtung bestimmt.

Nach der Prüfung der Funktionsfähigkeit der Sensorvorrichtung und des integrierten Schaltkreises in dem ersten Zustand, wird in einem zweiten Zustand die Testeinheit von dem Handler entfernt und in dem Handler das IC aus der Fassung gezogen. Anschließend wird mit dem Handler ein weiteres IC zur Prüfung in die Fassung eingebracht.

## Patentansprüche

1. Testsystem (10) mit einer Manipulationsvorrichtung (20), einer Testeinheit (30) und einem gehäusten integrierten Schaltkreis (60), wobei die Manipulationsvorrichtung (20) eine Aufnahmeeinheit (40) mit einer Fassung (50) aufweist und die Fassung (50) den gehäusten integrierten Schaltkreis (60) aufnimmt und der gehäuste integrierte Schaltkreis (60) eine Oberseite (62) und eine Unterseite (64) aufweist, und an der Unterseite (64) mehrere elektrische Anschlusskontakte (70) ausgebildet sind, und
zwischen der Fassung (50) und den Anschlusskontakten (70) eine elektrische Verbindung besteht und die Manipulationsvorrichtung (20) mittels der Aufnahmeeinheit (40) in einem ersten Zustand den integrierten Schaltkreis (60) für die Testeinheit (30) bereitstellt, und wobei
in dem ersten Zustand die Testeinheit (30) oberhalb der Oberseite (62) des integrierten Schaltkreises (60) angeordnet ist und mit der Manipulationsvorrichtung (20) eine Verbindung ausbildet und die Testeinheit (30) einen Funktionstest an dem integrierten Schaltkreis (60) ausführt,
**dadurch gekennzeichnet, dass**
der integrierte Schaltkreis (60) an der Oberseite (62) in dem Gehäuse eine Öffnung (80) mit einer in der Öffnung (80) ausgebildeten Sensoreinrichtung aufweist und die Oberseite (62) des integrierten Schaltkreises (60) in Richtung der Testeinheit (30) ausgerichtet ist und die elektrischen Anschlusskontakte (70) mit der Aufnahmeeinheit (40) der Manipulationsvorrichtung (20) elektrisch verbunden sind, um die Funktion der integrierten Sensoreinrichtung zu prüfen.

2. Testsystem (10) nach Anspruch 1, **dadurch gekennzeichnet, dass** die Aufnahmeeinheit (40) eine Kopplungsvorrichtung (42) aufweist und die Fassung (50) mittels der Kopplungsvorrichtung (42) mit der Testeinheit (30) elektrisch verbunden ist.

3. Testsystem (10) nach Anspruch 1 oder Anspruch 2, **dadurch gekennzeichnet, dass** die Testeinheit (30) eine Aufnahmevorrichtung (32) für die Kopplungseinrichtung (42) aufweist und die Aufnahmevorrichtung (32) eine elektrische Verbindung zwischen der Testeinheit (30) und der Kopplungseinrichtung (42) herstellt.

4. Testsystem (10) nach einem der Ansprüche 1 bis 3, **dadurch gekennzeichnet, dass** der integrierte Schaltkreis (60) an der Oberseite in dem Gehäuse eine Öffnung (80) mit einem in der Öffnung (80) ausgebildeten Lichtsensor aufweist.

5. Testsystem (10) nach einem der Ansprüche 1 bis 3, **dadurch gekennzeichnet, dass** der integrierte Schaltkreis (60) an der Oberseite (62) in dem Gehäuse eine Öffnung (80) aufweist

6. Testsystem (10) nach Anspruch 4, **dadurch gekennzeichnet, dass** in der Öffnung (80) ein Gassensor ausgebildet ist.

7. Testsystem (10) nach Anspruch 4, **dadurch gekennzeichnet, dass** in der Öffnung (80) ein Feuchtesensor ausgebildet ist.

8. Testsystem (10) nach einem der Ansprüche 1 bis 7, **dadurch gekennzeichnet, dass** die Testeinheit eine Gaskammer (90) aufweist und die Gaskammer während des ersten Zustandes mit der Oberfläche (62) des integrierten Schaltkreises (60) gasdicht verbunden ist.

9. Testsystem (10) nach Anspruch 8, **dadurch gekennzeichnet, dass** die Testeinheit eine Gaskammer (90) aufweist und die Gaskammer (90) während des ersten Zustandes mit der Oberfläche (62) des integrierten Schaltkreises (60) gasdicht verbunden ist, so dass die Öffnung (80) vollständig überdeckt wird.

10. Testsystem (10) nach Anspruch 7, **dadurch gekennzeichnet, dass** zwischen der Gaskammer (90) und der Oberfläche (62) des integrierten Schaltkreises (60) eine elastische Dichtlippe (92) ausgebildet ist.

11. Testsystem (10) nach einem der Ansprüche 8 bis 10, **dadurch gekennzeichnet, dass** in dem ersten Zustand innerhalb der Gaskammer (90) eine vorgegebene Gaskonzentration und / oder Feuchtekonzentration ausgebildet ist.

12. Verwendung des Testsystem (10) nach einem der Ansprüche 8 bis 11 zur Messung von elektrischen Parametern des elektrischen Schaltkreises (60) in Abhängigkeit wenigstens eines oder mehrere Parameter der Zusammensetzung des Gases innerhalb der Gaskammer (90).

## Claims

1. Test system (10) with a manipulation device (20), a testing unit (30) and a housed integrated circuit (60), wherein the manipulation device (20) comprises a receiving unit (40) with a mount (50) and the mount (50) receives the housed integrated circuit (60) and the housing integrated circuit (60) has an upper side (62) and a lower side (64), and a plurality of electrical connecting contacts (70) is formed at the lower side (64), and an electrical connection is present between the mount (50) and the connecting contacts (70) and the manipulation device (20) by means of the receiving unit (40) in a first state provides the integrated circuit (60) for the testing unit (30), and wherein in the first state the testing unit (30) is arranged above the upper side (62) of the integrated circuit (60) and forms a connection with the manipulation device (20) and the testing unit (30) executes a functional test at the integrated circuit (60), **characterised in that** the integrated circuit (60) has at the upper side (62) in the housing an opening (80) with a sensor device formed in the opening (80) and the upper side (62) of the integrated circuit (60) is oriented in the direction of the testing unit (30) and the electrical connecting contacts (70) are electrically connected with the receiving unit (40) of the manipulation device (20) in order to check the function of the integrated sensor device.

2. Test system (10) according to claim 1, **characterised in that** the receiving unit (40) comprises a coupling device (42) and the mount (50) is electrically connected with the testing unit (30) by means of the coupling device (42).

3. Test system (10) according to claim 1 or claim 2, **characterised in that** the testing unit (30) comprises a receiving device (32) for the coupling device (42) and the receiving device (32) produces an electrical connection between the testing unit (30) and the coupling device (42).

4. Test system (10) according to any one of claims 1 to 3, **characterised in that** the integrated circuit (60) has at the upper side in the housing an opening (80) with a light sensor formed in the opening (80).

5. Test system (10) according to any one of claims 1 to 3, **characterised in that** the integrated circuit (60) has an opening (80) at the upper side (62) in the housing.

6. Test system (10) according to claim 4, **characterised in that** a gas sensor is formed in the opening (80).

7. Test system (10) according to claim 4, **characterised in that** a moisture sensor is formed in the opening (80).

8. Test system (10) according to any one of claims 1 to 7, **characterised in that** the testing unit has a gas chamber (90) and the gas chamber during the first state is gastightly connected with the surface (62) of the integrated circuit (60).

9. Test system (10) according to claim 8, **characterised in that** the testing unit has a gas chamber (90) and the gas chamber (90) during the first state is gastightly connected with the surface (62) of the integrated circuit (60) so that the opening (80) is completely covered.

10. Test system (10) according to claim 7, **characterised in that** a resilient sealing lip (92) is formed between the gas chamber (90) and the surface (62) of the integrated circuit (60).

11. Test system (10) according to any one of claims 8 to 10, **characterised in that** in the first state a predetermined gas concentration and/or moisture concentration is or are formed within the gas chamber (90).

12. Use of the test system (10) according to any one of claims 8 to 11 for measuring electrical parameters of the electrical circuit (60) in dependence on at least one or more parameters of the composition of the gas within the gas chamber (90).

## Revendications

1. Système de test (10) avec un dispositif de manipulation (20), une unité de test (30) et un circuit intégré muni d'un boîtier (60), dans lequel le dispositif de manipulation (20) présente une unité de logement (40) avec une monture (50) et la monture (50) héberge le circuit intégré muni d'un boîtier (60) et le circuit intégré muni d'un boîtier (60) présente un côté supérieur (62) et un côté inférieur (64), et plusieurs contacts de raccordement électrique (70) sont formés sur le côté inférieur (64), et il existe une liaison électrique entre la monture (50) et les contacts de raccordement (70) et le dispositif de manipulation (20) fournit au moyen de l'unité de logement (40) dans un premier état le circuit intégré (60) pour l'unité de test (30), et dans lequel dans le premier état l'unité de test (30) est disposée au-dessus du côté supérieur (62) du circuit intégré (60) et forme une liaison avec le dispositif de manipulation (20) et l'unité de test (30) exécute un test de fonctionnement sur le circuit intégré (60), **caractérisé en ce que** le circuit intégré (60) présente sur le côté supérieur (62) dans le boîtier une ouverture (80) avec un dispositif de capteur formé dans l'ouverture (80) et le côté supérieur (62) du circuit intégré (60) est orienté en direction de l'unité de test (30) et les contacts de raccordement électrique (70) sont électriquement reliés à l'unité de logement (40) du dispositif de manipulation (20), afin de contrôler le fonctionnement du dispositif de capteur intégré.

2. Système de test (10) selon la revendication 1, **caractérisé en ce que** l'unité de logement (40) présente un dispositif de couplage (42) et la monture (50) est électriquement reliée à l'unité de test (30) au moyen du dispositif de couplage (42).

3. Système de test (10) selon la revendication 1 ou la revendication 2, **caractérisé en ce que** l'unité de test (30) présente un dispositif de logement (32) pour le dispositif de couplage (42) et le dispositif de logement (32) établit une liaison électrique entre l'unité de test (30) et le dispositif de couplage (42).

4. Système de test (10) selon l'une quelconque des revendications 1 à 3, **caractérisé en ce que** le circuit intégré (60) présente sur le côté supérieur dans le boîtier une ouverture (80) avec un capteur de lumière formé dans l'ouverture (80).

5. Système de test (10) selon l'une quelconque des revendications 1 à 3, **caractérisé en ce que** le circuit intégré (60) présente sur le côté supérieur (62) dans le boîtier une ouverture (80).

6. Système de test (10) selon la revendication 4, **caractérisé en ce qu'**un détecteur de gaz est formé dans l'ouverture (80).

7. Système de test (10) selon la revendication 4, **caractérisé en ce qu'**un détecteur d'humidité est formé dans l'ouverture (80).

8. Système de test (10) selon l'une quelconque des revendications 1 à 7, **caractérisé en ce que** l'unité de test présente une chambre à gaz (90) et la chambre à gaz est reliée pendant le premier état à la surface (62) du circuit intégré (60) de façon étanche au gaz.

9. Système de test (10) selon la revendication 8, **caractérisé en ce que** l'unité de test présente une chambre à gaz (90) et la chambre à gaz (90) est reliée pendant le premier état à la surface (62) du circuit intégré (60) de façon étanche au gaz, de telle manière que l'ouverture (80) soit entièrement recouverte.

10. Système de test (10) selon la revendication 7, **caractérisé en ce qu'**une lèvre d'étanchéité élastique (92) est formée entre la chambre à gaz (90) et la surface (62) du circuit intégré (60).

11. Système de test (10) selon l'une quelconque des revendications 8 à 10, **caractérisé en ce qu'**une concentration en gaz et/ou en humidité prédéterminée est formée dans le premier état à l'intérieur de la chambre à gaz (90).

12. Utilisation du système de test (10) selon l'une quelconque des revendications 8 à 11 pour la mesure de paramètres électriques du circuit électrique (60) en fonction d'au moins un ou plusieurs paramètres de la composition du gaz à l'intérieur de la chambre à gaz (90).
